# EUROPEAN PATENT SPECIFICATION

(11) **EP 3 577 759 B1**
(45) Date of publication and mention of the grant of the patent: **06.04.2022**
(21) Application number: 18706098.3
(22) Date of filing: 06.02.2018
(51) Int. Cl.: H04B 1/20, H04N 21/439, H03F 3/183, H04N 21/436, H04N 21/4363, H04N 21/233

(54) **A/V INTERCONNECTION ARCHITECTURE INCLUDING AN AUDIO DOWN-MIXING TRANSMITTER A/V ENDPOINT AND DISTRIBUTED CHANNEL AMPLIFICATION**
A/V-VERBINDUNGSARCHITEKTUR MIT EINEM TONABWÄRTSMISCHSENDER-A/V-ENDPUNKT UND VERTEILTER KANALVERSTÄRKUNG
ARCHITECTURE D'INTERCONNEXION A/V COMPRENANT UN POINT D'EXTRÉMITÉ A/V ÉMETTEUR À MÉLANGEUR ABAISSEUR AUDIO ET UNE AMPLIFICATION DE CANAL DISTRIBUÉE

(30) Priority: 06.02.2017 US 201762454915 P; 06.09.2017 US 201762555029 P
(43) Date of publication of application: 11.12.2019
(73) Proprietor: Savant Systems, Inc., Hyannis, MA 02601 (US)
(72) Inventor: ALLEN, James F., Hyannis Massachusetts 02601 (US); BALDINO, Gary M., Hyannis Massachusetts 02601 (US); BILLINGS, John D., Hyannis Massachusetts 02601 (US); LOCASCIO, Timothy R., Hyannis Massachusetts 02601 (US); MADONNA, Robert P., Hyannis Massachusetts 02601 (US)
(74) Representative: Rupprecht, Kay
(86) International application number: PCT/US2018/017087
(87) International publication number: WO 2018/145101

(56) References cited:
- EP-A1- 2 958 275
- KR-A- 20160 141 932
- US-A1- 2010 080 111
- US-A1- 2010 080 111
- US-A1- 2015 350 804
- US-A1- 2016 005 439
- US-A1- 2016 021 401
- US-A1- 2016 021 401
- US-A1- 2018 098 150
- "IEEE Standard for Local and metropolitan area networks--Audio Video Bridging (AVB) Systems;IEEE Std 802.1BA-2011", IEEE STANDARD, IEEE, PISCATAWAY, NJ, USA, 30 September 2011 (2011-09-30), pages 1-45, XP017694683, ISBN: 978-0-7381-6739-8

## Description

### BACKGROUND

### Technical Field

The present disclosure relates generally to audio/video (A/V) interconnection architectures, and more specifically to an A/V interconnection architecture that, among other features, efficiently supports devices having different audio capabilities.

### Background Information

Historically, A/V component connections were primarily one-way, single-purpose point-to-point analog connections. While analog connections gradually gave way to digital connections, they were still primarily one-way, single-purpose and point-to-point. This caused typical A/V interconnection architectures to involve large masses of cables, especially in high-end consumer and commercial installations.

There have been a variety of attempts to address the problems of traditional A/V interconnection architectures, by incorporating technologies such as IEEE 1394 (firewire), Audio over Ethernet (AoE), Audio over IP (ACIP) and other adaptations of computer network technologies. Some of the more promising approaches involve Audio Video Bridging (AVB) which is the common name for a set of standards set forth under Institute of Electrical and Electronics Engineers (IEEE) 802.2BA, 802.1AS, 802.1Qat and 802.1Qav. AVB implements relatively small extensions to standard IEEE 802.1 media access control (MAC) and bridging to better support audio, including providing precision synchronization and traffic shaping for audio and admission controls. However, the changes are limited to still allow AVB and non-AVB devices to communicate using standard IEEE 802 frames. Only AVB devices can make use of the extended audiospecific features however.

While technologies such as AVB have enabled certain more efficient A/V interconnection architectures, there are still a number of problems in such architectures. One problem in many such architectures is that they do not efficiently support devices having different audio capabilities (e.g., audio processing and output capabilities). For example, consider a typical high-end consumer A/V installation. A variety of A/V components may be disposed in different zones (e.g., a theater room zone, a kitchen zone, a master bedroom zone, etc.) of the structure (e.g., home). While some zones may include A/V components that support advanced types of surround sound audio (e.g., 10.2 surround sound with 12 total channels, 9.3.4 surround sound with 16 total channels, etc.) other zones may include A/V components that only support much more modest types of audio (e.g., stereo sound). In a typical A/V interconnection architecture that uses AVB, audio is typically only encoded in a single format for distribution (e.g., High-Definition Multimedia Interface (HDMI) audio according to a particular surround sound encoding). A/V components that only support much more modest types of audio (e.g., stereo sound) may not be able to process or output the audio stream, such that the audio content may not be available in certain zones of the structures, absent placement of special equipment in such zones.

Accordingly, there is a need for a new A/V interconnection architecture that, among other features, efficiently supports devices having different audio capabilities. The following non-patent literature document XP017694683 with the title "IEEE Standard for Local and metropolitan area networks--Audio Video Bridging (AVB) Systems;IEEE Std 802.1BA-2011" describes further relevant aspects concerning a network architercture comprsing AVB and non-AVB components.

### SUMMARY

The present invention is defined by the features of the independent claims 1 and 8. Further embodiments are defined in the dependent claims.

### BRIEF DESCRIPTION OF THE DRAWINGS

The description below refers to the accompanying drawings of example embodiments, of which:
Fig. 1 is a block diagram of an example A/V interconnection architecture;
Fig. 2 is a block diagram of connections of an example RX A/V endpoint, TX A/V endpoint, all-in-one audio system, powered speaker/sound bar and wireless audio bridge;
Fig. 3 is a block diagram of a typical implementation of the A/V interconnection architecture of Fig. 1 to support multiple A/V zones in a structure;
Fig. 4 is a schematic diagram of an example RX A/V endpoint;
Fig. 5 is a functional block diagram of audio processing in an example single-port TX A/V endpoint;
Fig. 6 is a schematic diagram of an example single-port TX A/V endpoint;
Figs. 7A and 7B are schematic diagrams of an example 8-port TX A/V endpoint, showing a main board and a TX riser card, respectively
Fig. 8A and 8B are schematic diagrams of an example powered sound bar and powered speaker; and
Fig. 9 is a schematic diagram of an example wireless powered speaker; and
Fig. 10 is a schematic diagram of an example wireless audio bridge.

### DETAILED DESCRIPTION

### An Example an A/V Interconnection Architecture

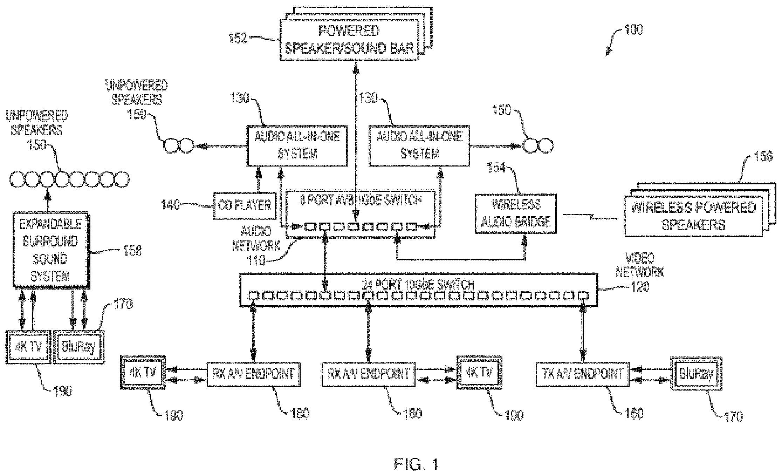

Fig. 1 is a block diagram of an example A/V interconnection architecture 100. The example architecture uses two packet-switched Ethernet networks for routing audio, video and control between various endpoints, that act as bridges between the networks and components that use native media connections (e.g., analog audio, digital audio, HDMI, RS232/IR, etc.). The first Ethernet network (hereinafter referred to as the "audio network") may be an AVB-compliant network (e.g., a 1 gigabyte Ethernet (GbE) network) centered around a multiport AVB-compliant audio network switch 110 (e.g., an 8-port 1GbE AVB switch). The audio network may be used to switch audio and general purpose Ethernet traffic. The second Ethernet network (hereinafter referred to as the "video network") may be a high-speed Internet Protocol (IP) network (e.g., a 10 GbE network) centered around a multiport video network switch 120 (e.g., a 24-port 10 GbE switch). The video network may be used to switch A/V, general purpose Ethernet, and optionally other control signals. A portion of the video network (e.g., 9 Gbs of bandwidth) may be reserved for use by A/V signals (e.g., HDMI), while the remainder (e.g., 1 Gbs of bandwidth) may be used for general purpose data and control signals. The audio network switch 110 and the video network switch 120 are connected by a link to allow for the exchange of audio and control between the audio network and the video network.

The audio network may be connected to audio/control endpoints that may be capable of multi-zone audio streaming, distribution and amplification (referred to hereinafter simply as "all-in-one audio systems") 130. One example all-in-one audio system 130 is the Pro Audio 4^{™} audio solution available from Savant Systems, Inc. An all-in-one audio system 130 may be coupled to dedicated audio source components 140 (e.g., a CD player) via native connections (e.g., analog audio, S/PDIF digital audio, RS232/IR, etc.) and audio sink components, such as unpowered speakers 150, via native connections (e.g., amplified analog audio).

The audio network may also be connected to transmitter audio/video/control endpoints (referred to hereinafter simply as "TX A/V endpoints") 160 either directly or through the video network. The TX A/V endpoints 160 may be coupled to A/V source components 170 (e.g., a Blu-ray player) that source both audio and video via native connections (e.g., HDMI, IR/RS232, standard Ethernet, etc.). As explained in more detail below, the TX A/V endpoints 160 may take various forms, including a 1-port form designed to be coupled to a single A/V source component 170 and a multi-port (e.g., 8-port) form designed to be coupled to multiple A/V source components 170. Communication on the audio network may be conducted using IEEE P1722 format audio packets, in accord with AVB standards.

The audio network may also be connected to powered speakers/sound bars 152 that operate as audio sink components. Powered speakers/sound bars 152 may include an audio processor, amplifier and speakers, so that they can receive using IEEE P1722 format audio packets in accord with AVB standards and generate therefrom sound. The audio network may also be connected to a wireless audio bridge (e.g., an AVB to Wireless Speaker and Audio (WISA) bridge) that operates to convert IEEE P1722 format audio packets to multiple wireless audio streams (e.g., multiple WISA streams). The wireless audio streams (e.g., WISA streams) are then transmitted to wireless powered speakers 156 that amplify and output the audio.

The audio network may also be connected to an expandable surround sound system 158 that is coupled to one or more dedicated A/V source component 170, such as a Blu-ray player, via native connections (e.g., native HDMI), and an A/V sink component 190 (e.g., an ultra high-definition (4K) television) via a native connection (e.g., native HDMI). The expandable surround sound system 158 may also be coupled to audio sink components, such as unpowered speakers 150, via native connections (e.g., amplified analog audio), which may be used to output at least some channels of surround sound audio. If a number of audio channels exceeds the number of locally supported unpowered speakers 150 (or for architectural or other reasons), one or more channels of the audio may be output on the audio network for playback on devices that include amplification circuitry, such as an all-in-one system 130 in combination with unpowered speakers 150, a powered speakers/sound bars 152 or a wireless audio bridge 154 in combination with a wireless powered speakers 156, to provide "add on" channels of audio.

The video network may be connected to receiver audio/video/control endpoints (referred to hereinafter simply as "RX A/V endpoints") 180. An RX A/V endpoint 180 may be coupled to an A/V sink component 190 (e.g., a 4K television) that sinks video via native connections (e.g. HDMI, RS232/IR, standard Ethernet, etc.). The video network may also be connected to the TX A/V endpoints 160. Communication on the video network may be conducted (on the portion of the video network reserved for A/V) according to HDMI standards.

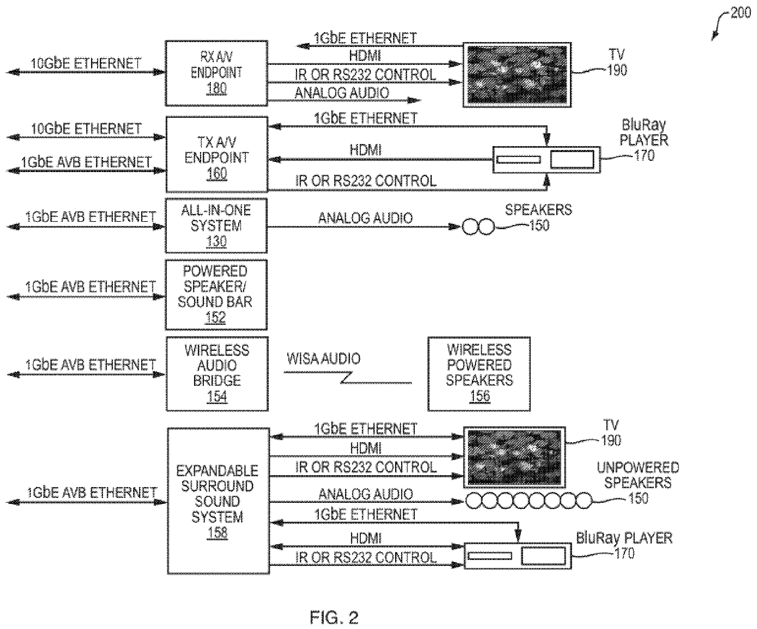

Fig. 2 is a block diagram 200 of connections of an example RX A/V endpoint 180, TX A/V endpoint, all-in-one audio system 130, powered speaker/sound bar 142 and wireless audio bridge 154. In this example, the RX A/V endpoint 180 is coupled via a high-speed Ethernet connection (e.g., a 10 GbE connection) to the video network switch 120 (not shown) of the video network. The RX A/V endpoint 180 is also coupled to an example A/V sink component 190, for example a 4K television, via a native HDMI connection, RS232 or IR control connection, Ethernet data connection and an analog audio connection. The TX A/V endpoint 160 is coupled via a high-speed Ethernet connection (e.g., a 10 GbE connection) to the video network switch 120 (not shown) of the video network and via an AVB Ethernet connection (e.g., a 1 GbE AVB connection) to the audio network switch 110 (not shown) of the audio network (such connection may be indirect, e.g., accessing the audio network via the video network). The TX A/V endpoint 160 is also coupled to an example A/V source component 170, for example a Blu-ray player, via a native HDMI connection, RS232 or IR control connection, and Ethernet data connection. The all-in-one audio system 130 is coupled via an AVB Ethernet connection (e.g., a 1 GbE AVB connection) to the audio network switch 110 (not shown) of the audio network. The all-in-one audio system 130 is also coupled to an example audio sink component, for example unpowered speakers 150, via a native amplified analog audio outputs. The all-in-one audio system 130 may also have native audio input connections (e.g., analog audio or S/PDIF digital audio input connections). The powered speaker/sound bar 152 is coupled via an AVB Ethernet connection (e.g., a 1 GbE AVB connection) to the audio network switch 110 (not shown) of the audio network. The powered speaker/sound bar 152 itself is capable of operating as an sink component. The wireless audio bridge 154 (e.g., the AVB to WISA bridge) is coupled via an AVB Ethernet connection (e.g., a 1 GbE AVB connection) to the audio network switch 110 (not shown) of the audio network and via a wireless connection (e.g. a WISA connection) to wireless powered speakers 156 that amplify the audio and operate as audio sink components. The expandable surround sound system 158 is coupled via an AVB Ethernet connection (e.g., a 1 GbE AVB connection) to the audio network switch 110 (not shown) of the audio network. The expandable surround sound system 158 is also coupled to an A/V source component 170, for example a Blu-ray player, via a native HDMI connection, RS232 or IR control connection, and Ethernet data connection, and an A/V sink component 190, for example a 4K television, via a native HDMI connection, RS232 or IR control connection, and Ethernet data connection, and to a number of unpowered speakers 150 (e.g., 8 speakers) via amplified analog audio outputs.

Referring to both Fig. 1 and Fig. 2, in operation, a TX A/V endpoint 160 may receive audio and video via a native A/V connection (e.g., HDMI connection) from an A/V source component 170. The audio portion may be encoded in a native format (e.g., as compressed HDMI audio with advanced surround sound). The TX A/V endpoint 160 may route the video portion in its native format (e.g., as native HDMI video) over the video network via video switch 120 to the RX A/V endpoints 180. Further, the TX A/V endpoint 160 may route the audio portion (e.g., the HDMI-originated audio) in its native format (e.g., as native HDMI audio) along with a stereo down-mixed version (e.g., stereo down-mixed HDMI PCM audio) over the video network via video switch 120 to the RX A/V endpoints 180, for playback on A/V sink components 190. Depending on the audio capabilities of A/V sink components 190, either the native format or the stereo down-mixed version of the audio may be received and utilized at each RX A/V endpoint 180. Further, the TX A/V endpoint 160 may route the native format (e.g., as native HDMI audio) and stereo down-mixed version of the audio (e.g., the HDMI-originated stereo down-mixed PCM audio) to the all-in-one audio systems 130 over the audio network via audio switch 110, for playback on unpowered speakers 150, to powered speakers/sound bars 152 for playback directly thereon and to the wireless audio bridge 154 for conversion to wireless audio (e.g., in accord with WISA standards) that is received and played back on wireless powered speakers 156. In addition, the TX A/V endpoint 160 may receive audio over the audio network via video switch 120. The TX A/V endpoint 160 may route this audio over the video network to the RX A/V endpoints 180, for playback on A/V sink components 190.

Likewise, referring to both Fig. 1 and Fig. 2, in operation an example expandable surround sound system may receive audio and video via a native A/V connection (e.g., HDMI connection) from an A/V source component 170. The example expandable surround sound system 158 may direct a native video portion to an A/V sink component 190, such as a 4K television, which outputs the video portion. The native audio portion may be decoded into a plurality of channels for advanced surround sound (e.g., a plurality of PCM audio channels for 10.2 surround sound with 12 channels, 9.3.4 surround sound with 16 total channels, etc.). At least some (e.g., 8 channels) may be locally amplified and output to attached unpowered speakers 150. However, if the number of audio channels exceeds the available local output channels (or for architectural or other considerations), the remaining channels may be handled as "add on" channels, and packetized and output over the audio network (e.g., as AVB PCM audio). The channels may be received and played back by devices that include amplification circuitry, such as an all-in-one system 130, powered speaker/sound bar 152 or wireless audio bridge 154 in combination with wireless powered speakers 156, which function as "add ons" to the expandable surround sound system 158.

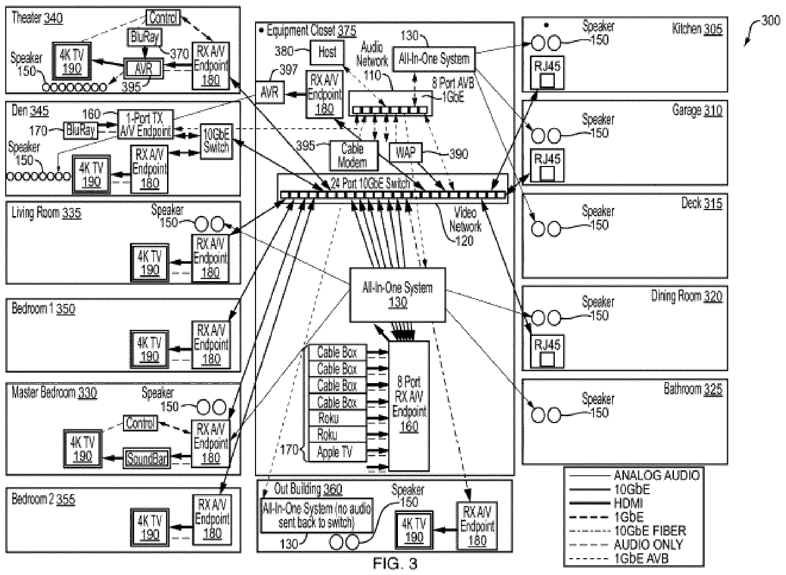

Fig. 3 is a block diagram of a typical implementation 300 of the A/V interconnection architecture of Fig. 1 to support multiple A/V zones in a structure (e.g., a home). In this example, there are eight analog audio zones 305-335 (named "Kitchen", "Garage", "Deck", etc.) driven from all-in-one audio systems 130, seven A/V zones 330, 335-360 (named "Master Bedroom", "Living Room", "Theater", etc., noting that some zones are both analog audio zones and A/V zones) driven from the RX A/V endpoints 180, of which two zone 340, 345 support advanced surround sound and five zone 330, 335, 350-360 only support stereo sound, and eight switched A/V source components 170 (and one dedicated A/V source component 370 that is not accessible to other zones). The audio network switch 110 and the video network switch 120 may be disposed in a location separate from the zones, in this example an equipment closet 375, along with other A/V and home automation devices, such as a host controller 380 that provides control signals (for example, to A/V sink component 190 and A/V source component 170), wireless access point (WAP) 390, cable modem 395, etc. Some all-in-one audio systems 130, RX A/V endpoints 180, TX A/V endpoints 160, as well as other devices such as audio/video receivers (AVRs) 397, may be disposed in the zones, while others are centrally located in the equipment closet 375.

### An Example RX A/V Endpoint

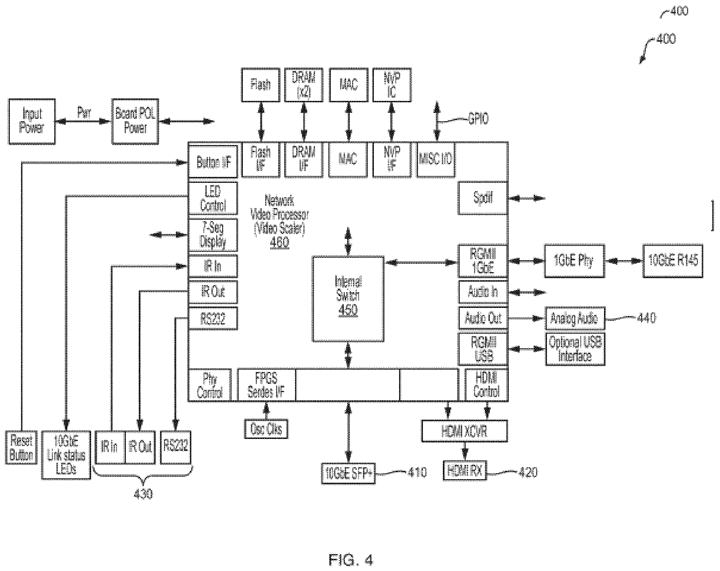

Fig. 4 is a schematic diagram 400 of an example RX A/V endpoint 180. The RX A/V endpoint 180 has an interface 410 for a high-speed Ethernet connection to the video network (e.g., a 10 GbE connection, of which 9 Gsb of bandwidth are reserved for A/V and 1 Gbs of bandwidth is used for general purpose data and control signals), as well as interfaces for native connections, such as an HDMI interface 420, RS232 or IR control interfaces 430, and an analog audio interface 440, among others. The RX A/V endpoint may include a number of internal hardware components, including an internal Ethernet switch 450, a video processor (video scaler) 460 (that may scale the video content, according to a genlock mode, multi-viewer mode, video wall mode, fast switch mode or other mode of operation), memory, timing circuitry, and interface controls, among other hardware.

The RX A/V endpoint 180 may receive audio and video from a TX A/V endpoint 160 via the video network, where the audio is encoded in a native format (e.g., compressed HDMI audio, with advanced surround sound), and pass the audio portion in the native format on a native connection, specifically the HDMI interface 420, to an A/V sink component 190 that supports the native audio. Alternatively, the RX A/V endpoint 180 may receive audio and video from TX A/V endpoints 160 via the video network, where the audio is a stereo down-mixed version (e.g., stereo down-mixed HDMI PCM audio), and pass the audio portion on a native connection, specifically the HDMI interface 420, to an A/V sink component 190 that only supports a stereo down-mixed version.

### Example TX A/V Endpoints

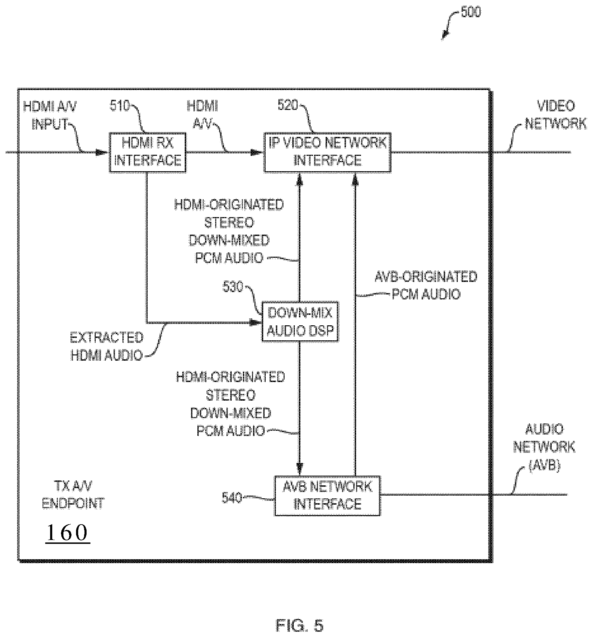

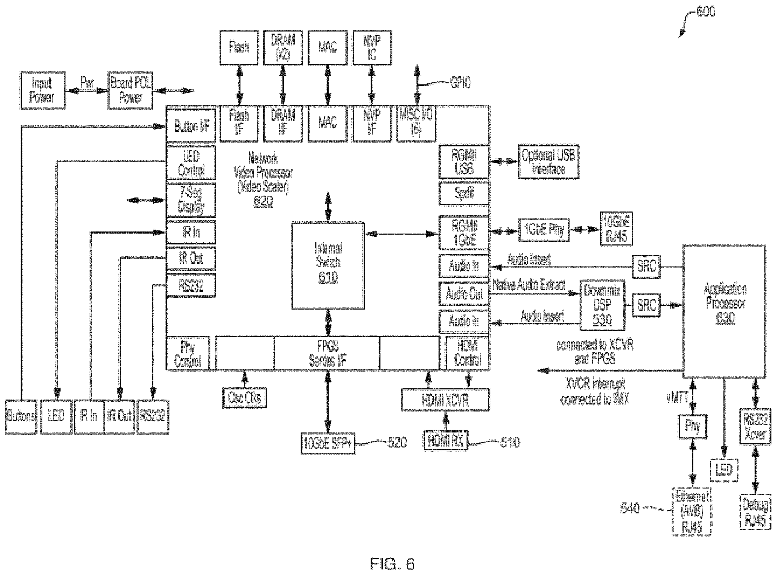

Fig. 5 is a functional block diagram 500 of audio processing in an example single-port TX A/V endpoint. Fig. 6 is a schematic diagram 600 of an example single-port TX A/V endpoint. Fig. 6 includes hardware components that have been abstracted from Fig. 5, such as an internal Ethernet switch 610, a video scaler 620, application processor 630 for control and AVB functions, and display and interface controllers, among other hardware. The single-port TX A/V endpoint can receive native audio and video, where the audio portion is in a native format (e.g., compressed HDMI audio, with advanced surround sound) via a native A/V interface, such as a HDMI receive (RX) interface 510, from an A/V source component 170. The native video may be passed to a video scaler 610 that may scale the video content, according to a genlock mode, multi-viewer mode, video wall mode, fast switch mode or other mode of operation. The native audio and potentially-scaled video (e.g., the HDMI-originated audio and video) may be passed to an IP video network interface 520, and directly output over the video network (as native HDMI audio and video) via video switch 120 to the RX A/V endpoints 180. Further, the audio portion of the native audio and video may be extracted, and passed to a down-mix audio digital signal processor (DSP) 530, which produces a stereo down-mixed version (e.g., stereo down-mixed PCM audio). This stereo down-mixed version is then passed to the video network interface 520 for output over the video network via video switch 120 to the RX A/V endpoints 180 (e.g., as stereo down-mixed HDMI PCM audio). Further, the stereo down-mixed version (e.g., the HDMI-originated stereo down-mixed PCM audio) is also passed to an AVB network interface 540 and output over the audio network via audio switch 110 (e.g., as AVB PCM audio) to devices such as all-in-one audio systems 130, powered speakers/sound bars 152 and wireless audio bridge 154 in combination with wireless powered speakers 156. In addition, the AVB network interface 540 may receive audio (e.g., AVB-originated PCM audio) from devices such as all-in-one audio systems 130 over the audio network via audio switch 110. This audio (e.g., AVB-originated PCM audio) is passed to the IP video network interface 520 and output (e.g., as HDMI PCM audio) over the video network via video switch 120 to the RX A/V endpoints 180, for playback on A/V sink components 190. Further, the IP video network interface 520 may receive control signals from a host controller over the video network that are, at least in part, passed to the source component 170 via an interface (e.g., an IP interface, IR interface, RS232 interface, etc.) (not shown).

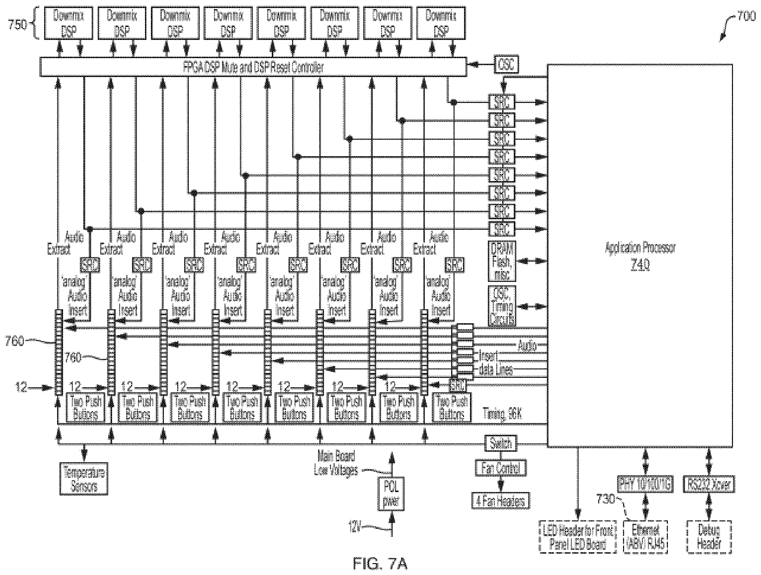

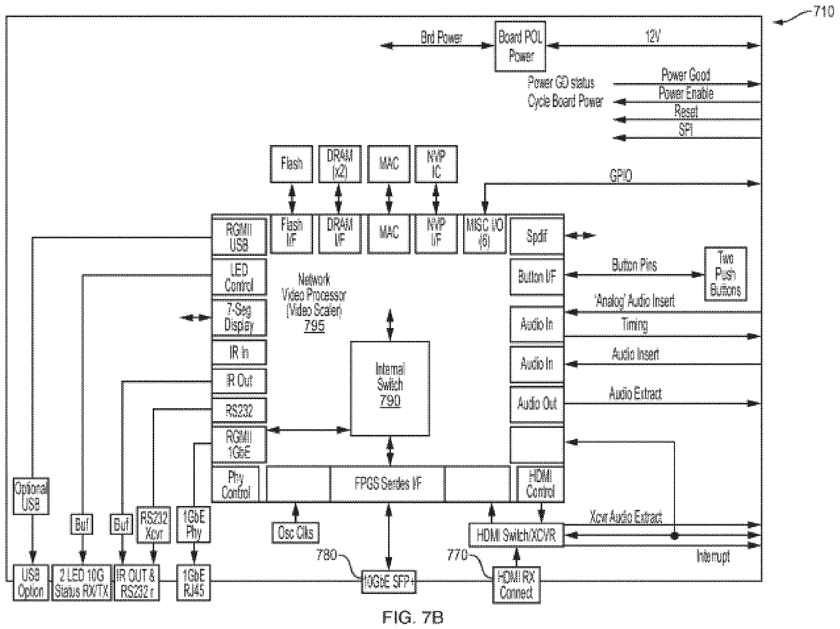

In addition to a single-port configuration, RX A/V endpoints 180 may be configured in multi-point configurations (e.g., an 8-port RX A/V endpoint) where certain hardware is shared among all ports. Figs. 7A and 7B are schematic diagrams 700, 710 of an example 8-port TX A/V endpoint, showing a main board and a TX riser card, respectively. The main board may include an AVB network interface 730, two application processors 740 for control and AVB functions, eight down-mix audio DSPs 750, and eight connectors for TX riser cards 760, as well as an FPGA, memory, timing circuitry, interface controls, and other hardware. Each TX riser card may include a native A/V interface, such as an HDMI RX interface 770, an IP video network interface 780, an internal Ethernet switch 790, and a video scaler 795, among other hardware.

The 8-port TX A/V endpoint may operate similar to a single port TX A/V endpoint, while providing greater connectivity. The 8-port TX A/V endpoint may receive audio and video on the native A/V interfaces 770 on the TX riser cards from A/V source components 170. The native video may be passed to a video scaler 795 on the respective TX riser card that may scale the video content. The native audio and potentially-scaled video (e.g., the HDMI-originated audio and video) may be passed to the IP video network interface 780 on the respective TX riser card and directly output over the video network (as native HDMI audio and video) via video switch 120 to the RX A/V endpoints 180. Further, the audio portion of the native audio and video may be extracted, and passed to a down-mix audio DSP 750 corresponding to the respective TX riser card, which produces a stereo down-mixed version (e.g., as stereo down-mixed PCM audio) that is then passed to the IP video network interface 780 on the respective TX riser card for output over the video network via video switch 120 to the RX A/V endpoints 180 (e.g., as stereo down-mixed HDMI PCM audio). Further, the stereo down-mixed version (e.g., the HDMI-originated stereo down-mixed PCM audio) is also passed to the AVB network interface 730 and output over the audio network via audio switch 110 (e.g., as AVB PCM audio) to devices such as all-in-one audio systems 130, powered speakers/sound bars 152 and wireless audio bridge 154 in combination with wireless powered speakers 156. In addition, the AVB network interface 730 may receive audio (e.g., AVB-originated PCM audio) from devices such as all-in-one audio systems 130 over the audio network via audio switch 110. This audio (e.g., AVB-originated PCM audio) is passed to an IP video network interface 750 on one of the TX riser cards and output (e.g., as HDMI PCM audio) over the video network to the RX A/V endpoints 180, for playback on A/V sink components 190.

### Example Powered Sound Bar and Powered Speaker

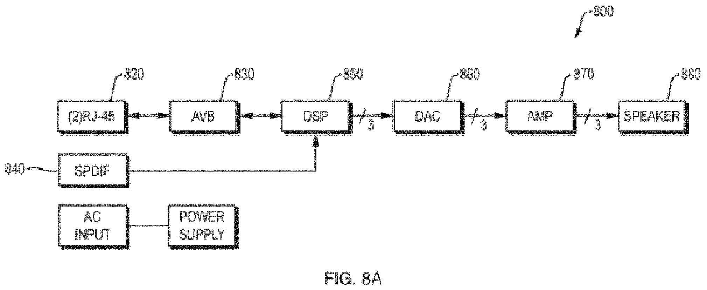

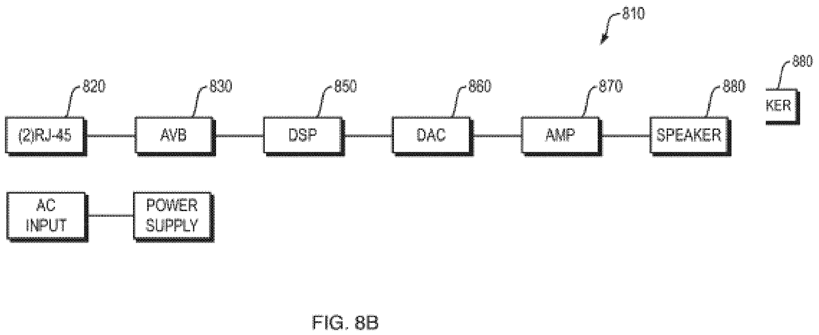

Fig. 8A and 8B are schematic diagrams of an example powered sound bar 800 and powered speaker 810 (collectively referred to as powered speaker/sound bar 152). The powered speaker/sound bar has an interface 820 and decoding circuitry 830 for a connection to the audio network (e.g., a 1 GbE AVB connection), as well as, in the case of the sound bar 800, interfaces for native connections, such as a SPDIF interface 840. The powered speaker/sound bar may include a number of internal hardware components, including a DSP, digital to analog converter (DAC), and audio amplifier. Amplified audio is supplied to one or more (e.g., in the case of the sound bar, for example, 3) internally mounted speakers 880.

The powered speaker/sound bar may be powered by an alternating current (AC) input and power supply. Alternatively, the powered speaker/sound bar may be powered by a direct current (DC), for example, a Power over Ethernet (POE) injected into the audio network and received via the interface 820.

### Example Wireless Powered Speaker

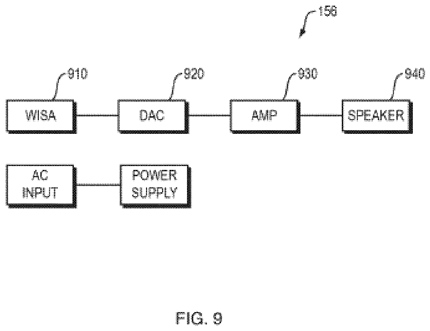

Fig. 9 is a schematic diagram of an example wireless powered speaker 156. The wireless powered speaker 900 has a wireless interface 910 (including an antenna and decoding circuitry) for receiving a wireless audio stream (e.g., a WISA audio stream). The wireless powered speaker 900 may include a number of internal hardware components, including a DAC 920 and audio amplifier 930. Amplified audio is supplied to one or internally mounted speakers 940.

### Example Wireless Audio Bridge

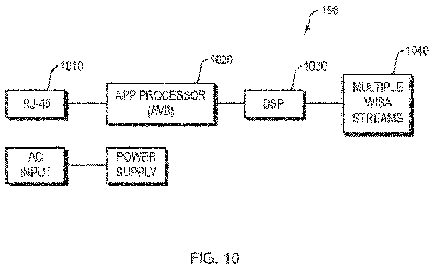

Fig. 10 is a schematic diagram of an example wireless audio bridge 154. The wireless audio bridge 154 has an interface 1010 and application processor 1020 for a connection to the audio network (e.g., a 1 GbE AVB connection) and decoding received audio packets. The wireless audio bridge 154 also includes a DSP 1030 configured to process and generate multiple wireless audio stream 1040 therefrom.

It should be understood that various adaptations and modifications may be made to the above discussed A/V interconnection architecture and its methods of operation. While it is discussed above that operations may be performed on specific hardware devices (such as on TX A/V endpoints 160, the RX A/V endpoints 180, all-in-one audio systems 130, powered speaker/sound bars 152, wireless audio bridges 154, expandable surround sound system 158, etc.), it should be understood that operations may be executed on different hardware. Additionally, it should be understood that at least some of the functionality described above to be implemented in software. In general functionality may be implemented in software, hardware or various combinations thereof. Software implementations may include electronic device-executable instructions (e.g., computer-executable instructions) stored in a non-transitory electronic device-readable medium (e.g., a non-transitory computer-readable medium), such as a volatile or persistent memory, a hard-disk, a compact disk (CD), or other tangible medium. Hardware implementations may include logic circuits, application specific integrated circuits, and/or other types of hardware components. Further, combined software/hardware implementations may include both electronic device-executable instructions stored in a non-transitory electronic device-readable medium, as well as one or more hardware components, for example, processors, memories, etc. Above all, it should be understood that the above embodiments are meant to be taken only by way of example.

Fig. 10 is a schematic diagram of an example wireless audio bridge 154. The wireless audio bridge 154 has an interface 1010 and application processor 1020 for a connection to the audio network (e.g., a 1 GbE AVB connection) and decoding received audio packets. The wireless audio bridge 154 also includes a DSP 1030 configured to process and generate multiple wireless audio stream 1040 therefrom.

Example Expandable Surround Sound System which is not covered by the claims.

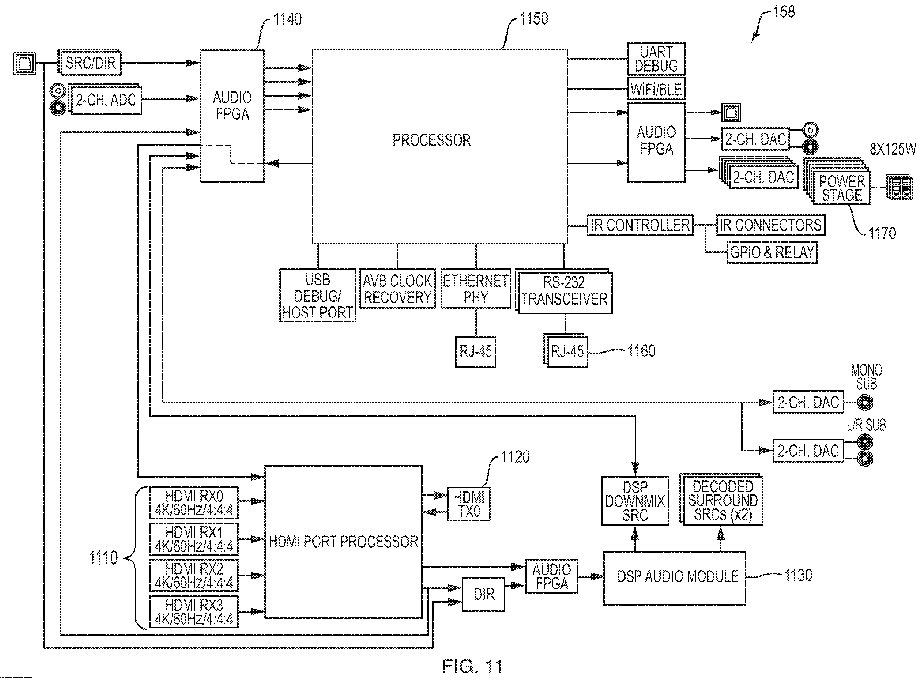

Fig. 11 is a schematic diagram of an example expandable surround sound system 158. The expandable surround sound system 158 can receive native audio and video, where the audio portion is in a native format (e.g., compressed HDMI audio, with advanced surround sound) via native A/V interfaces such as HDMI RX interfaces 1110, from an A/V source component 170. The native video may be passed to a HDMI TX interface 1120 coupled to an A/V sink component 190, such as a 4K television, which outputs the video portion. The native audio may be provided to a DSP audio module 1130 that decodes the native audio into a plurality of channels for advanced surround sound (e.g., a plurality of PCM audio channels for 10.2 surround sound with 12 channels, 9.3.4 surround sound with 16 total channels, etc.), as well as a stereo down-mixed version (e.g., stereo down-mixed PCM audio). The stereo down-mixed version (e.g., stereo down-mixed PCM audio) may be output locally, or passed via an audio FPGA 1140 and processor 1150 to a network interface 1060 for output over a remote device. At least some (e.g., 8 channels) of the plurality of channels for advanced surround sound may be passed to local amplification circuitry 1170 via the processor 1150. The remaining channels for advanced surround sound may be packetized and passed via an audio FPGA 1140 and processor 1150 to a network interface 1060 for output over the audio network 110 (e.g., as AVB PCM audio). The channels may be received and played back by devices that include amplification circuitry, such as an all-in-one system 130, powered speaker/sound bar 152 or wireless audio bridge 154 in combination with wireless powered speakers 156.

It should be understood that various adaptations and modifications may be made to the above discussed A/V interconnection architecture and its methods of operation. While it is discussed above that operations may be performed on specific hardware devices (such as on TX A/V endpoints 160, the RX A/V endpoints 180, all-in-one audio systems 130, powered speaker/sound bars 152, wireless audio bridges 154, expandable surround sound system 158, etc.), it should be understood that operations may be executed on different hardware. Additionally, it should be understood that at least some of the functionality described above to be implemented in software. In general functionality may be implemented in software, hardware or various combinations thereof. Software implementations may include electronic device-executable instructions (e.g., computer-executable instructions) stored in a non-transitory electronic device-readable medium (e.g., a non-transitory computer-readable medium), such as a volatile or persistent memory, a hard-disk, a compact disk (CD), or other tangible medium. Hardware implementations may include logic circuits, application specific integrated circuits, and/or other types of hardware components. Further, combined software/hardware implementations may include both electronic device-executable instructions stored in a non-transitory electronic device-readable medium, as well as one or more hardware components, for example, processors, memories, etc. Above all, it should be understood that the above embodiments are meant to be taken only by way of example.

## Claims

1. An audio/video, A/V, interconnection architecture (100) comprising:
a non-Audio Video Bridging, AVB,-compliant Ethernet network including a first network switch (120);
an AVB-compliant Ethernet network including a second network switch (110);
a receive, RX, A/V endpoint (180) coupled to the non-AVB-compliant Ethernet network and an A/V sink component (190) that is capable of processing or outputting native audio;
an audio system (130) coupled to the AVB-compliant Ethernet network and an audio sink component (150) that is incapable of processing or outputting the native audio;
a transmit, TX, A/V, endpoint (160) including:
at least one receive, RX, interface (510) configured to be coupled to an A/V source component and to receive the native audio from the A/V source component (170),
a first network interface (520) coupled to the at least one RX interface and configured to receive the native audio from the at least one RX interface and output the native audio over the non-AVB-compliant Ethernet network to the RX A/V endpoint;
a down-mix audio digital signal processor, DSP, (530) coupled to the at least one RX interface and configured to produce a stereo down-mixed version of the native audio; and
a second network interface (540) configured to output the down-mixed version over the AVB-compliant Ethernet network to the audio system.

2. The A/V interconnection architecture of claim 1, wherein the second network interface is further configured to receive an audio signal from the audio system coupled to the audio sink component and forward the audio signal to the first network interface, and the first network interface is configured to output the audio signal over the non-AVB-compliant Ethernet network to the RX A/V endpoint coupled to the A/V sink component.

3. The A/V interconnection architecture of claim 1, wherein the native audio is High-Definition Multimedia Interface, HDMI, audio and the stereo down-mixed version of the native audio is stereo down-mixed pulse code modulated, PCM, audio.

4. The A/V interconnection architecture of claim 1, wherein the RX interface is further configured to receive native video from the A/V source component and to forward the native video signal to the first network interface to be output over the non-AVB-compliant Ethernet network to the RX A/V endpoint coupled to the A/V sink component, but to withhold the native video from the down-mix audio DSP and second network interface.

5. The A/V interconnection architecture of claim 4, wherein the native audio is High-Definition Multimedia Interface, HDMI, audio, the native video is HDMI video, and the stereo down-mixed version of the native audio is stereo down-mixed pulse code modulated, PCM, audio.

6. The A/V interconnection architecture of claim 1, wherein the at least one RX interface is a plurality of RX interfaces that each are configured to receive native audio from a respective A/V source component of a plurality of A/V source components, the DSP is configured to produce a stereo down-mixed PCM version of the native audio from each respective A/V source component, and the second network interface is configured to output the down-mixed PCM version for each respective A/V source component over the AVB-compliant Ethernet network.

7. The A/V interconnection architecture of claim 1, wherein the first network interface is further configured to receive control signals from a host controller (380) over the non-AVB-compliant Ethernet network and to pass at least a portion of the control signals to the at least one RX interface for transmission to the A/V source component.

8. A method for distributing audio using a transmit, TX, audio/video, A/V, endpoint (160) of an A/V interconnection architecture (100), comprising:
receiving, by the TX A/V endpoint, at least native audio from the A/V source component;
outputting, by the TX A/V endpoint, the native audio over a non-AVB-compliant Ethernet network to an RX A/V endpoint (180) coupled to an A/V sink component (190) that is capable of processing or outputting the native audio;
down-mixing, by the TX A/V endpoint, the native audio to produce a stereo down-mixed pulse code modulated,PCM, version of the native audio; and
outputting, by the TX A/V endpoint, the down-mixed PCM version over an Audio Video Bridging, AVB,-compliant Ethernet network to an audio system (130) coupled to an audio sink component (150) that is incapable of processing or outputting the native audio.

9. The method of claim 8, further comprising
receiving, by the TX A/V endpoint, a PCM audio signal from the audio system coupled to the audio sink component; and
outputting, by the TX A/V endpoint, the PCM audio signal over the non-AVB-compliant Ethernet network to the RX A/V endpoint coupled to the A/V sink component.

10. The method of claim 8, wherein the native audio is High-Definition Multimedia Interface, HDMI, audio.

11. The method of claim 8, further comprising:
receiving, by the TX A/V endpoint, native video from the A/V source component;
outputting the native video over the Ethernet video network to the RX A/V endpoint coupled to the A/V sink component, but withholding the native video from being output over the AVB-compliant Ethernet network to the audio system coupled to the audio sink component.

12. The method of claim 11, wherein the native audio is High-Definition Multimedia Interface, HDMI, audio, the native video is HDMI video.

13. The method of claim 8, further comprising:
receiving, by the TX A/V endpoint, control signals from a host controller (380) over the non-AVB-compliant Ethernet network; and
transmitting at least a portion of the control signals to the A/V source component.

14. The method of claim 8, wherein outputting the native audio over the non-AVB-compliant Ethernet network transmits the native audio to a first multi-port network switch and the outputting the down-mixed PCM version over the AVB-compliant Ethernet network transmits the down-mixed PCM version to a second AVB-compliant multi-port network switch, wherein the first multi-port network switch is coupled by at least one link to the second AVB-compliant multi-port network switch

## Patentansprüche

1. Audio-/Video- (AV) Verbindungsarchitektur (100), umfassend:
ein mit Audio Video Bridging (AVB) nicht konformes Ethernet-Netzwerk, das einen ersten Netzwerk-Switch (120) einschließt;
ein mit AVB konformes Ethernet-Netzwerk, das einen zweiten Netzwerk-Switch (110) einschließt;
einen AV-Empfangs- (RX) Endpunkt (180), der mit dem mit AVB nicht konformen Ethernet-Netzwerk und einer AV-Senken-Komponente (190) gekoppelt ist, die imstande ist, Native Audio zu verarbeiten oder auszugeben; ein Audiosystem (130), das mit dem mit AVB konformen Ethernet-Netzwerk und einer Audio-Senken-Komponente (150) gekoppelt ist, die nicht imstande ist, das Native Audio zu verarbeiten oder auszugeben;
einen AV-Übertrage- (TX) Endpunkt (160), umfassend:
mindestens eine Empfangs- (RX) Schnittstelle (510), die konfiguriert ist, um mit einer AV-Quellen-Komponente gekoppelt zu werden und das Native Audio von der AV-Quellen-Komponente (170) zu empfangen,
eine erste Netzwerkschnittstelle (520), die mit der mindestens einen RX-Schnittstelle gekoppelt ist und konfiguriert ist, das Native Audio von der mindestens einen RX-Schnittstelle zu empfangen und das Native Audio über das mit AVB nicht konforme Ethernet-Netzwerk an den RX AV-Endpunkt auszugeben;
einen digitalen Abwärtsmisch-Audiosignalprozessor, DSP, (530), der mit der mindestens einen RX-Schnittstelle gekoppelt ist und konfiguriert ist, eine abwärtsgemischte Stereoversion des Native Audio zu erzeugen; und
eine zweite Netzwerkschnittstelle (540), die konfiguriert ist, die abwärtsgemischte Version über das mit AVB konforme Ethernet-Netzwerk an das Audiosystem auszugeben.

2. AV-Verbindungsarchitektur nach Anspruch 1, wobei die zweite Netzwerkschnittstelle des Weiteren konfiguriert ist, ein Audiosignal von dem mit der Audio-Senken-Komponente gekoppelten Audiosystem zu empfangen und das Audiosignal von der ersten Netzwerkschnittstelle weiterzuleiten, und die erste Netzwerkschnittstelle konfiguriert ist, das Audiosignal über das mit AVB nicht konforme Ethernet-Netzwerk an den mit der AV-Senken-Komponente gekoppelten RX AV-Endpunkt auszugeben.

3. AV-Verbindungsarchitektur nach Anspruch 1, wobei das Native Audio ein Audio der hochauflösenden Multimedia-Schnittstelle (HDMI) ist, und die abwärtsgemischte Stereoversion des Native Audio ein abwärtsgemischtes, pulscodemoduliertes (PCM) Stereo-Audio ist.

4. AV-Verbindungsarchitektur nach Anspruch 1, wobei die RX-Schnittstelle des Weiteren konfiguriert ist, Native Video von der AV-Quellen-Komponente zu empfangen und das native Videosignal an die erste Netzwerkschnittstelle weiterzuleiten, um über das mit AVB nicht konforme Ethernet-Netzwerk an den mit der AV-Senken-Komponente gekoppelten RX AV-Endpunkt ausgegeben zu werden, jedoch das Native Video von Abwärtsmisch-Audio-DSP und zweiter Netzwerkschnittstelle zu verweigern.

5. AV-Verbindungsarchitektur nach Anspruch 4, wobei das Native Audio ein Audio der hochauflösenden Multimedia-Schnittstelle (HDMI) ist, das Native Video HDMI-Video ist und die abwärtsgemischte Stereoversion des Native Audio ein abwärtsgemischtes, pulscodemoduliertes (PCM) Stereo-Audio ist.

6. AV-Verbindungsarchitektur nach Anspruch 1, wobei die mindestens eine RX-Schnittstelle eine Vielzahl von RX-Schnittstellen ist, die jeweils konfiguriert sind, um Native Audio von einer entsprechenden AV-Quellen-Komponente einer Vielzahl von AV-Quellen-Komponenten zu empfangen, der DSP konfiguriert ist, eine abwärtsgemischte PCM-Stereoversion des Native Audio von jeder entsprechenden AV-Quellen-Komponente zu erzeugen, und die zweite Netzwerkschnittstelle konfiguriert ist, die abwärtsgemischte PCM-Version für jede entsprechende AV-Quellen-Komponente über das mit AVB konforme Ethernet-Netzwerk auszugeben.

7. AV-Verbindungsarchitektur nach Anspruch 1, wobei die erste Netzwerkschnittstelle des Weiteren konfiguriert ist, Steuersignale von einem Host-Controller (380) über das mit AVB nicht konforme Ethernet-Netzwerk zu empfangen und mindestens einen Teil der Steuersignale an die mindestens eine RX-Schnittstelle zur Übertragung an die AV-Quellen-Komponente durchzulassen.

8. Verfahren zum Verteilen von Audio mittels eines Übertrage- (TX) Audio/Video- (AV) Endpunktes (160) einer AV-Verbindungsarchitektur (100), umfassend: Empfangen, durch den TX AV-Endpunkt, von zumindest Native Audio von der AV-Quellen-Komponente;
Ausgeben, durch den TX AV-Endpunkt, des Native Audio über ein mit AVB nicht konformes Ethernet-Netzwerk an einen mit einer AV-Senken-Komponente (190) gekoppelten RX AV-Endpunkt (180), die imstande ist, das Native Audio zu verarbeiten oder auszugeben;
Abwärtsmischen, durch den TX AV-Endpunkt, des Native Audio, um eine abwärtsgemischte, pulscodemodulierte (PCM) Stereoversion des Native Audio zu erzeugen; und
Ausgeben, durch den TX AV-Endpunkt, der abwärtsgemischten PCM-Version über ein mit Audio Video Bridging (AVB) konformes Ethernet-Netzwerk an ein mit einer Audio-Senken-Komponente (150) gekoppeltes Audiosystem (130), die nicht imstande ist, das Native Audio zu verarbeiten oder auszugeben.

9. Verfahren nach Anspruch 8, des Weiteren umfassend:
Empfangen, durch den TX AV-Endpunkt, eines PCM-Audiosignals von dem mit der Audio-Senken-Komponente gekoppelten Audiosystem; und
Ausgeben, durch den TX AV-Endpunkt, des PCM-Audiosignals über das mit AVB nicht konforme Ethernet-Netzwerk an den mit der AV-Senken-Komponente gekoppelten RX AV-Endpunkt.

10. Verfahren nach Anspruch 8, wobei das Native Audio ein Audio der hochauflösenden Multimedia-Schnittstelle (HDMI) ist.

11. Verfahren nach Anspruch 8, des Weiteren umfassend:
Empfangen, durch den TX AV-Endpunkt, von Native Video von der AV-Quellen-Komponente;
Ausgeben des Native Video über das Ethernet-Videonetzwerk an den mit der AV-Senken-Komponente gekoppelten RX AV-Endpunkt, jedoch verweigern, dass das Native Video über das mit AVB konforme Ethernet-Netzwerk an das mit der Audio-Senken-Komponente gekoppelten Audiosystem ausgegeben wird.

12. Verfahren nach Anspruch 11, wobei das Native Audio ein Audio der hochauflösenden Multimedia-Schnittstelle (HDMI) ist, das Native Video ein HDMI-Video ist.

13. Verfahren nach Anspruch 8, des Weiteren umfassend:
Empfangen, durch den TX AV-Endpunkt, von Steuersignalen von einem Host-Controller (380) über das mit AVB nicht konforme Ethernet-Netzwerk; und
Übertragen von zumindest einem Teil der Steuersignale an die AV-Quellen-Komponente.

14. Verfahren nach Anspruch 8, wobei Ausgeben des Native Audio über das mit AVB nicht konforme Ethernet-Netzwerk das Native Audio zu einem ersten Multiport-Netzwerk-Switch überträgt und das Ausgeben der abwärtsgemischten PCM-Version über das mit AVB konforme Ethernet-Netzwerk die abwärtsgemischte PCM-Version zu einem mit AVB konformen, zweiten Multiport-Netzwerk-Switch überträgt, wobei der erste Multiport-Netzwerk-Switch durch mindestens eine Übertragungsstrecke mit dem mit AVB konformen, zweiten Multiport-Netzwerk-Switch gekoppelt ist.

## Revendications

1. Architecture d'interconnexion audio / vidéo, A/V (100), comprenant :
un réseau Ethernet non conforme à un pontage audio vidéo, AVB, comportant un premier commutateur de réseau (120) ;
un réseau Ethernet conforme à l'AVB comportant un second commutateur de réseau (110) ;
un point d'extrémité A/V récepteur, RX (180) couplé au réseau Ethernet non conforme à l'AVB, et un composant collecteur A/V (190), qui peut traiter ou fournir l'audio natif ;
un système audio (130) couplé au réseau Ethernet conforme à l'AVB et un composant collecteur audio (150), qui ne peut pas traiter ou fournir l'audio natif ;
un point d'extrémité A/V émetteur, TX (160) comportant :
au moins une interface récepteur, RX (510), configurée pour être couplée à un composant source A/V et pour recevoir l'audio natif à partir du composant source A/V (170),
une première interface de réseau (520), couplée à l'au moins une interface RX et configurée pour recevoir l'audio natif à partir de l'au moins une interface RX et fournir l'audio natif sur le réseau Ethernet non conforme à l'AVB vers le point d'extrémité A/V RX ;
un processeur de signal numérique d'audio mélangé abaissé, DSP (530), couplé à l'au moins une interface RX et configuré pour produire une version mélangée abaissée stéréo de l'audio natif; et
une seconde interface de réseau (540), configurée pour fournir la version mélangée abaissée sur le réseau Ethernet conforme à l'AVB vers le système audio.

2. Architecture d'interconnexion A/V selon la revendication 1, dans laquelle la seconde interface de réseau est configurée en outre pour recevoir un signal audio à partir du système audio, couplé au composant collecteur audio et pour transmettre le signal audio à la première interface de réseau, et la première interface de réseau est configurée pour fournir le signal audio sur le réseau Ethernet non conforme à l'AVB vers le point d'extrémité A/V RX, couplé au composant collecteur A/V.

3. Architecture d'interconnexion A/V selon la revendication 1, dans laquelle l'audio natif est l'Interface Multimédia Haute Définition, HDMI, audio et la version mélangée abaissée stéréo de l'audio natif est mélangée abaissée stéréo modulé par impulsion et codage PCM, audio.

4. Architecture d'interconnexion A/V selon la revendication 1, dans laquelle l'interface RX est configurée en outre pour recevoir la vidéo native à partir du composant source A/V et pour transmettre le signal vidéo native vers la première interface de réseau pour être fourni sur le réseau Ethernet non conforme à l'AVB vers le point d'extrémité A/V RX, couplé au composant collecteur A/V, mais pour retenir la vidéo native de l'audio mélangé abaissé DSP et la seconde interface de réseau.

5. Architecture d'interconnexion A/V selon la revendication 4, dans laquelle l'audio natif et l'Interface Multimédia Haute Définition, HDMI, audio, et la vidéo native est HDMI vidéo, et la version mélangée abaissée stéréo de l'audio natif est mélangée abaissée stéréo modulé par impulsion et codage PCM, audio.

6. Architecture d'interconnexion A/V selon la revendication 1, dans laquelle l'au moins une interface RX est une pluralité d'interfaces RX, qui sont chacune configurées pour recevoir l'audio natif à partir d'un composant source A/V respectif d'une pluralité de composants source A/V, le DSP est configuré pour produire une version PCM mélangée abaissée stéréo de l'audio natif à partir de chaque composant source A/V respectif, et la seconde interface de réseau est configurée pour fournir la version PCM mélangée abaissée pour chaque composant source A/V respectif sur le réseau Ethernet conforme à l'AVB.

7. Architecture d'interconnexion A/V selon la revendication 1, dans laquelle la première interface de réseau est configurée en outre pour recevoir des signaux de commande à partir d'un contrôleur hôte (380) sur le réseau Ethernet non conforme à l'AVB, et pour transmettre au moins une partie des signaux de commande vers l'au moins une interface RX pour transmission au composant source A/V.

8. Procédé pour la distribution d'audio en utilisant un point d'extrémité audio/vidéo, A/V, émetteur, TX (160) d'une architecture d'interconnexion A/V (100) comprenant :
la réception, par le point d'extrémité A/V TX d'au moins l'audio natif à partir du composant source A/V ;
la fourniture, par le point d'extrémité A/V TX, de l'audio natif sur un réseau Ethernet non conforme à l'AVB vers un point d'extrémité A/V RX (180),
couplé à un composant collecteur A/V (190), qui peut traiter ou fournir l'audio natif ;
le mélange-abaissement, par le point d'extrémité A/V TX, de l'audio natif pour produire une version mélangée abaissée stéréo modulé par impulsion et codage, PCM, de l'audio natif ; et
la fourniture, par le point d'extrémité A/V TX, de la version PCM mélangée abaissée sur un réseau Ethernet conforme à un pontage audio vidéo, AVB, vers un système audio (130), couplé à un composant collecteur audio (150), qui ne peut pas traiter ou fournir l'audio natif.

9. Procédé selon la revendication 8, comprenant en outre :
la réception, par le point d'extrémité A/V TX, d'un signal audio PCM à partir du système audio, couplé au composant collecteur audio ;
et
la fourniture, par le point d'extrémité A/V TX, du signal audio PCM sur le réseau Ethernet non conforme à l'AVB vers le point d'extrémité A/V RX, couplé au composant collecteur A/V.

10. Procédé selon la revendication 8, dans lequel l'audio natif est l'Interface Multimédia Haute Définition, HDMI, audio.

11. Procédé selon la revendication 8, comprenant en outre :
la réception, par le point d'extrémité A/V TX, de la vidéo native à partir du composant source A/V ;
la fourniture de la vidéo native sur le réseau vidéo Ethernet vers le point d'extrémité A/V RX, couplé au composant collecteur A/V, mais l'empêchement de la fourniture de la vidéo native sur le réseau Ethernet conforme à l'AVB vers le système audio, couplé au composant collecteur audio.

12. Procédé selon la revendication 11, dans lequel l'audio natif est l'Interface Multimédia Haute Définition, HDMI, audio, la vidéo native est la HDMI vidéo.

13. Procédé selon la revendication 8, comprenant en outre :
la réception, par le point d'extrémité A/V TX, des signaux de commande à partir d'un contrôleur hôte (380) sur le réseau Ethernet non conforme à l'AVB ; et
la transmission de l'au moins une partie des signaux de commande vers le composant source A/V.

14. Procédé selon la revendication 8, dans lequel la fourniture de l'audio natif sur le réseau Ethernet non conforme à l'AVB transmet l'audio natif vers un premier commutateur de réseau multiport, et la fourniture de la version PCM mélangée abaissée sur le réseau Ethernet conforme à l'AVB transmet la version PCM mélangée abaissée vers un second commutateur de réseau multiport conforme à l'AVB, dans lequel le premier commutateur de réseau multiport est couplé par au moins une liaison au second commutateur de réseau multiport conforme à l'AVB.
